# EUROPÄISCHE PATENTSCHRIFT

(11) **EP 1 493 230 B1**
(45) Veröffentlichungstag und Bekanntmachung des Hinweises auf die Patenterteilung: **25.03.2009**
(21) Anmeldenummer: 03727277.0
(22) Anmeldetag: 03.04.2003
(51) Int. Cl.: H03K 17/945

(54) **ELEKROMAGNETISCHES ZUHALTESYSTEM EINES SICHERHEITSSCHALTERS**
ELECTROMAGNETIC LOCKING SYSTEM FOR A SAFETY SWITCH
SYSTEME DE VERROUILLAGE ELECROMAGNETIQUE D'UN INTERRUPTEUR DE SECURITE

(30) Priorität: 08.04.2002 DE 10216225
(43) Veröffentlichungstag der Anmeldung: 05.01.2005
(73) Patentinhaber: EUCHNER GmbH + Co. KG, 70771 Leinfelden-Echterdingen (DE)
(72) Erfinder: BAECHLE, Erik, 70794 Filderstadt (DE); LINK, Walter, 71277 Rutesheim (DE)
(74) Vertreter: Crazzolara, Helmut
(86) Internationale Anmeldenummer: PCT/EP2003/003494
(87) Internationale Veröffentlichungsnummer: WO 2003/085833

(56) Entgegenhaltungen:
- DE-A- 19 937 947
- DE-A- 19 953 898
- DE-C- 19 840 620

## Beschreibung

Die vorliegende Erfindung betrifft ein Zuhaltesystem eines Sicherheitsschalters mit einem Betätiger nach dem Oberbegriff des Anspruchs 1.

Sicherheitsschalter mit einem Lesekopf und einem Betätiger, die jeweils eine erste bzw. zweite Baugruppe mit elektrischen und/oder elektronischen Bauelementen aufweisen, die elektrisch kontaktlos in Wechselwirkung miteinander bringbar sind und dadurch den Sicherheitsschalter steuern, sind beispielsweise aus der DE 197 11 588 A1 bekannt. Mit derartigen Sicherheitsschaltern können bewegliche Schutzeinrichtungen überwacht werden, wie beispielsweise Türen, Abdeckungen, Gitter und dgl., von Maschinen und Anlagen. In der Regel unterbricht der Sicherheitsschalter beim Öffnen der Schutzeinrichtung einen oder mehrere Stromkreise, wodurch die zugehörige Maschine in einen sicheren Betriebszustand überführt wird, beispielsweise abgeschaltet wird, oder deren Einschalten verhindert wird.

Der Betätiger wird in der Regel in einen vom Lesekopf ausgebildeten Kanal eingeführt. Im zusammengeführten Zustand ist der Betätiger im Lesekopf mechanisch verriegelbar und dadurch die Schutzeinrichtung zuhaltbar. Das Zuhalten erfolgt nach dem Stand der Technik aufgrund des Durchgreifens einer Öffnung in dem Betätiger unmittelbar durch einen Stößel oder durch das Blockieren eines mit dem Betätiger zusammenwirkenden Schaltrades im Lesekopf. Damit die abhängig vom Anwendungsfall erforderlichen Zuhaltekräfte von beispielsweise 1000 N aufgebracht werden können, ist das Zuhaltesystem und mithin der Sicherheitsschalter entsprechend mechanisch robust auszuführen.

Alternativ oder ergänzend zur mechanischen Verriegelung kann die Zuhaltung auch durch elektromagnetische Kräfte erfolgen, die allerdings stark abhängig sind von dem Abstand zwischen dem Elektromagneten und dem zugehörigen Gegenelement, insbesondere mit zunehmendem Abstand stark abnehmen. In schmutzenden Umgebungen, wie beispielsweise in der Nähe von spanenden Bearbeitungsmaschinen, kann die auftretende Verschmutzung des Sicherheitsschalters und des Zuhaltesystems die Bereitsstellung hoher Zuhaltekräfte und auch die sonstige Funktion beeinträchtigen.

Aus der DE 199 53 898 A1 ist eine Zugangsschutzeinrichtung mit einem U-förmigen Haltemagneten bekannt. Im Ausführungsbeispiel ist eine Anordnung mit einem drehbaren U-förmigen Permanentmagneten beschrieben, wobei ein erster Reed-Kontakt die Drehstellung des Permanentmagneten detektiert, d.h. das Ein- oder Ausschalten der Magnetwirkung der Zuhaltung, und ein zweiter Reed-Kontakt detektiert, ob das Gegenstück vorhanden ist oder nicht, d.h., ob die Schutztür geschlossen ist oder nicht.

Aus der DE 198 40 620 C1 ist ein berührungsloser Sicherheitsschalter bekannt mit einem am Lesekopf angeordneten Hall-Sensor und einem am Betätiger angeordneten Permanentmagneten. Der Hall-Sensor überwacht die Schließstellung, wobei die Schaltschwelle des Hall-Sensors mit einem Trimmwiderstand einstellbar ist.

Der vorliegenden Erfindung liegt das Problem zugrunde, ein Zuhaltesystem eines Sicherheitsschalters weiter zu verbessern, insbesondere die Zuhaltung durch elektromagnetische Kräfte zuverlässig zu kontrollieren.

Das Problem ist durch das im Anspruch 1 bestimmte Zuhaltesystem gelöst. Besondere Ausführungsarten sind in den Unteransprüchen bestimmt.

Das Problem ist bei einem Zuhaltesystem eines Sicherheitsschalters mit einem Lesekopf und einem Betätiger, die jeweils eine erste bzw. zweite Baugruppe mit elektrischen und/oder elektronischen Bauelementen aufweisen, die elektrisch kontaktlos in Wechselwirkung miteinander bringbar sind und dadurch den Sicherheitsschalter steuern, dadurch gelöst, dass der Betätiger am Lesekopf mittels eines mit einem Gegenelement zusammenwirkenden schaltbaren Elektromagneten zuhaltbar ist, und dass mittels eines Sensorelements, dessen Ausgangssignal abhängig ist von dem durch den Elektromagneten generierbaren Magnetfeld, die Zuhaltung kontrollierbar ist.

Keine der Druckschriften aus dem Stand der Technik zeigt ein Sensorelement, das ein analoges Ausgangssignal bereitstellt, mit dem die Stärke des Magnetfeldes eines Elektromagneten kontrollierbar ist und mithin die erzeugte Zuhaltekraft. Diese Zuhaltekraft ist bei erfindungsgemäßer Verwendung eines Elektromagneten einstellbar, durch entsprechende elektrische Ansteuerung auch stufenlos einstellbar. Demgegenüber ist im Stand der Technik durch die bekannten Sensorelemente jeweils nur ein Schaltzustand oder eine Position diskret und digital ermittelt, beispielsweise ob der Permanentmagnet in Zuhalteposition gedreht ist, oder ob die Schutztür geschlossen ist. Durch die Einstellbarkeit der Zuhaltekraft können auch unterschiedliche Betriebszustände der zu überwachenden Maschine automatisch und insbesondere programmgesteuert mit unterschiedlichen Zuhaltekräften für die zugehörige Schutzeinrichtung verknüpft werden.

Die elektrisch kontaktlose Wechselwirkung zwischen Lesekopf und Betätiger kann mit allen aus dem Stand der Technik bekannten Verfahren realisiert werden, im einfachsten Fall durch eine Dämpfung elektromagnetischer Wellen, insbesondere eines elektromagnetischen Feldes. Alternativ dazu kann auch ein sogenanntes Transponder-System eingesetzt werden, bei dem zwischen Lesekopf und Betätiger elektrisch kontaktlos Identifikationssignale ausgetauscht werden. Nach dem Stand der Technik wird der räumliche Ansprechbereich des Wechselwirkungssystems nur begrenzt ausgenützt und es ist ein verhältnismäßig exaktes Ausrichten von Lesekopf und Betätiger im zusammengeführten Zustand zueinander erforderlich.

Die Zuhaltung erfolgt nicht oder jedenfalls nicht ausschließlich durch einen quer zur Bewegungsrichtung des Betätigers verschiebbaren Riegel, sondern durch elektromagnetische Krafteinwirkung auf das Gegenelement. Der Elektromagnet ist durch den Sicherheitsschalter selbst und/oder eine zugehörige Steuereinrichtung und/oder durch die zum Sicherheitsschalter zugehörige Maschine schaltbar. Die Höhe der Zuhaltekraft kann einstellbar sein, beispielsweise in Abhängigkeit des Betriebszustandes der zugehörigen Maschine. Vorzugsweise ist das Gegenelement und/oder der Elektromagnet gegenüber dem Grundelement schwenkbar gelagert. Beim Zuhalten sind der Elektromagnet und der Betätiger so nah benachbart, dass ausreichend hohe Zuhaltekräfte realisierbar sind. Weiterhin ist vorzugsweise die erste und/oder zweite Baugruppe in dem jeweiligen Gegenelement integriert, wodurch eine Wechselwirkung der Baugruppen auch unter ungünstigen Umständen zuverlässig gewährleistet ist, beispielsweise auch bei einem Winkelversatz der Schutzeinrichtung.

In einer besonderen Ausführungsart ist das Sensorelement in dem Betätiger angeordnet. Vorzugsweise weist der Betätiger weiterhin das Grundelement, das Gegenelement und die zweite Baugruppe auf, insbesondere ist der Betätiger durch diese Elemente gebildet. Alternativ oder ergänzend kann auch der Lesekopf ein oder mehrere Sensorelemente aufweisen. Beispielsweise ist denkbar, daß die durch das Gegenelement hervorgerufene Bedämpfung des vom Elektromagneten generierten Magnetfeldes auch direkt im Lesekopf gemessen werden kann.

Unabhängig von der Anzahl und Anordnung des einen oder der mehreren Sensorelemente kann die Steuerung des Sicherheitsschalters durch unmittelbare oder mittelbare Kopplung des Ausgangssignals des Sensors und der Wechselwirkung der ersten und zweiten Baugruppe erfolgen. Eine unmittelbare Kopplung ist beispielsweise dann gegeben, wenn die erste und/oder zweite Baugruppe nur dann betreibbar ist, wenn das Sensorelement ein entsprechendes Ausgangssignal bereitstellt. Eine mittelbare Kopplung ist beispielsweise dann gegeben, wenn von einer übergeordneten Steuerelektronik das Ausgangssignal der ersten und/oder zweiten Baugruppe empfangen wird und unabhängig davon auch das Ausgangssignal des Sensorelements empfangen wird. Eine Verknüpfung der beiden Ausgangssignale erfolgt dann in der übergeordneten Steuerelektronik, die beispielsweise auch darüber entscheidet, ob ein Betriebszustand der zu überwachenden Maschine vorliegt, für den das Ausgangssignal des Sensorelements relevant ist.

In einer bevorzugten Ausführungsart der Erfindung sind von dem Sensorelement in Abhängigkeit des von dem Elektromagneten generierbaren Magnetfeldes zwei Schaltzustände einnehmbar. Vorzugsweise wird von diesen Schaltzuständen des Sensorelements die in dem Betätiger angeordnete zweite Baugruppe gesteuert. Dies hat den Vorteil, daß der Betätiger ohne äußere elektrische Anschlüsse realisiert werden kann. Alle erforderlichen elektrischen oder sonstigen Verbindungen sind innerhalb des Betätigers realisiert und vorzugsweise gegen störende Einflüsse mechanischer oder sonstiger Art von außen geschützt angeordnet. Das Sensorelement kann auch unmittelbar an oder in der zweiten Baugruppe des Betätigers angeordnet oder in diese integriert sein. Für viele Anwendungszwecke wird es allerdings vorteilhaft sein, wenn das Sensorelement von der zweiten Baugruppe beabstandet auf dem Betätiger angeordnet ist. Vorzugsweise ist mindestens ein Sensorelement in einen Randbereich des Betätigers angeordnet, um auf diesem Wege nicht oder jedenfalls nicht nur einen axialen Abstand zu dem Elektromagneten ermitteln zu können, sondern auch einen Versatz in einer Richtung senkrecht zur Bewegungsrichtung der Relativbewegung zwischen Elektromagneten und Betätiger.

In einer bevorzugten Ausführungsform der Erfindung ist in dem Betätiger eine Generatorspule zur elektrischen Energieversorgung der zweiten Baugruppe angeordnet. In der Regel empfängt diese Generatorspule ein elektromagnetisches Signal von der ersten Baugruppe des Lesekopfes und erzeugt aus diesem Signal die erforderliche Spannung bzw. den erforderlichen Strom zum Betrieb der elektrischen und/oder elektronischen Bauelemente.

In einer besonders einfachen Ausführungsart der Erfindung ist das Sensorelement elektrisch in Reihe mit der Generatorspule geschaltet. Dadurch ist es möglich, die elektrische Energieversorgung für die zweite Baugruppe im Betätiger nur dann aufzuschalten, wenn das Sensorelement ein ausreichend hohes oder ausreichend geringes von dem Elektromagneten generiertes Magnetfeld detektiert.

Soweit mehrere Sensorelemente auf dem Betätiger und/oder dem Lesekopf angeordnet sind, können deren Ausgangssignale zur Kontrolle der Zuhaltung in einer vorgebbaren Weise miteinander verknüpft werden. Vorteilhaft ist insbesondere eine entsprechend den jeweiligen Anforderungen und Geometrien vorgenommene räumliche oder jedenfalls flächige Verteilung der mehreren Sensorelemente, beispielsweise auf der Anlagefläche des Betätigers. Dadurch kann auch die Relativposition des Betätigers in Bezug auf den Elektromagneten im zugehaltenen Zustand ermittelt werden.

Die Position eines oder mehrerer der Sensorelemente kann durch individuelle oder gemeinsame Einstellmittel einstellbar sein. Die Einstellung kann grundsätzlich in allen drei Raumrichtungen linear und/oder in rotatorische Richtungen möglich sein. Für viele Anwendungsfälle wird es aber insbesondere auf eine Einstellmöglichkeit in Richtung der Relativbewegung zwischen Betätiger und Elektromagneten oder rechtwinklig hierzu ankommen.

In einer besonderen Ausführungsart weist das Sensorelement einen Reed-Kontakt und/oder ein Hall-Elemente auf, insbesondere kann das Sensorelement durch einen Reed-Kontakt oder ein Hall-Element gebildet sein. Ein Hall-Element besitzt gegenüber einem Reed-Kontakt den Vorteil, daß nicht nur ein oder mehrere Schaltpunkte vorgebbar sind, sondern daß ein analoges Ausgangssignal betreffend die Stärke des von dem Elektromagneten generierten Magnetfeldes erzeugbar ist.

Weitere Vorteile, Merkmale und Einzelheiten der Erfindung ergeben sich aus den Unteransprüchen sowie der nachfolgenden Beschreibung, in der unter Bezugnahme auf die Zeichnungen mehrere Ausführungsbeispiele im Einzelnen beschrieben sind. Dabei können die in den Ansprüchen und in der Beschreibung erwähnten Merkmale jeweils einzeln für sich oder in beliebiger Kombination erfindungswesentlich sein.
- Fig. 1: zeigt eine perspektivische Ansicht des Lesekopfes eines Sicherheitsschalters mit einem erfindungsgemäßen Zuhaltesystem,
- Fig. 2: zeigt eine perspektivische Ansicht eines zugehörigen Betätigers,
- Fig. 3a: zeigt ein erstes Ausführungsbeispiel der zweiten Baugruppe, in der eine Generatorspule sowie ein Transponder angeordnet ist,
- Fig. 3b: zeigt ein zweites Ausführungsbeispiel der-zweiten Baugruppe bei welcher der Transponder unmittelbar an die Generatorspule angeschlossen ist,
- Fig. 4: zeigt einen Schnitt durch den Lesekopf und den Betätiger des Zuhaltesystems im zusammengeführten Zustand,
- Fig. 5: zeigt das Zuhaltesystem der Fig. 4 in verändertem Zustand,
- Fig. 6: zeigt ein Diagramm der gemessenen Zuhaltekraft, und
- Fig. 7: zeigt in schematischer Darstellung eine Schutzeinrichtung.

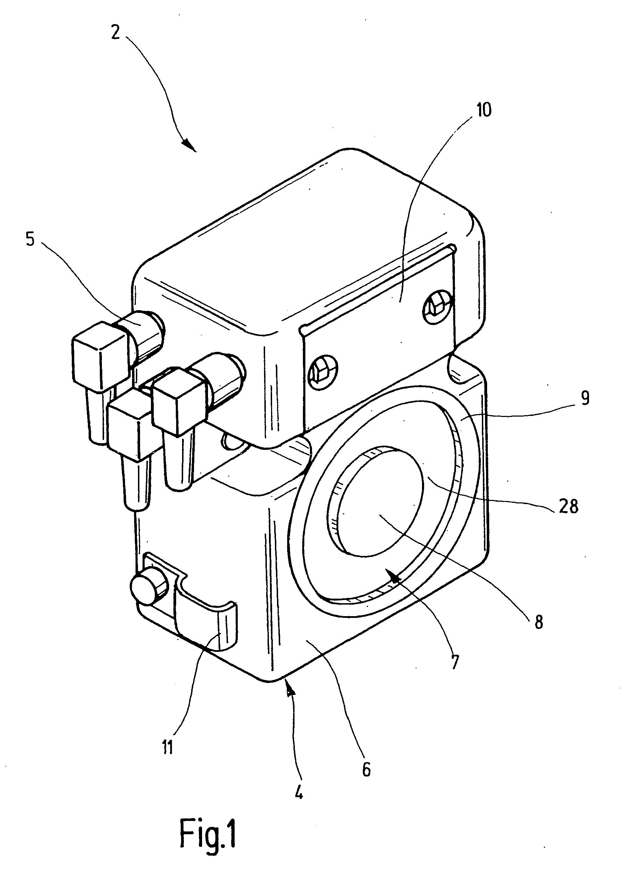

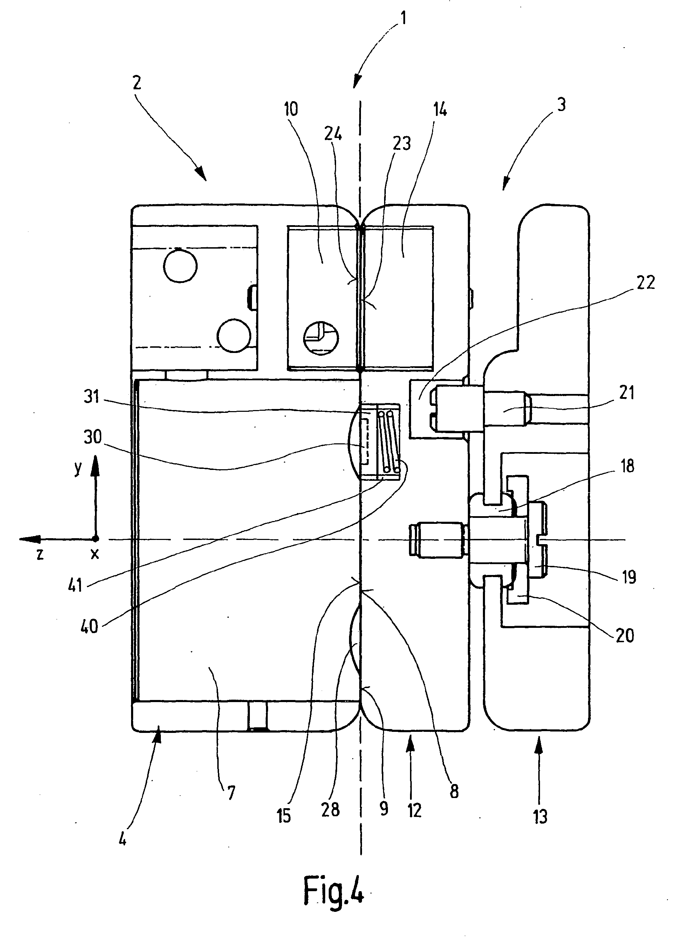

Die Fig.1 zeigt eine perspektivische Ansicht des Lesekopfes 2 eines Sicherheitsschalters mit einem erfindungsgemäßen Zuhaltesystem 1 (Fig. 4). Der Lesekopf 2 ist mindestens Teil des nicht weiter dargestellten Sicherheitsschalters. Die elektrische Schaltfunktion kann innerhalb des Kopfgehäuses 4 ausgeführt werden oder in einem von dem Kopfgehäuse 4 entfernt angeordneten Schalterteil des Sicherheitsschalters. Die elektrische Kontaktierung des Lesekopfes 2 erfolgt über einen oder mehrere Steckverbinder 5. Das Kopfgehäuse 4 ist im wesentlichen quaderförmig mit einer im wesentlichen rechteckförmigen und vorzugsweise planen Frontfläche 6. Unterhalb des Mittelpunktes weist das Kopfgehäuse 4 eine kreiszylindrische Bohrung auf, deren Längsachse mit der Frontfläche 6 einen rechten Winkel einschließt und in die der Elektromagnet 7 einsetzbar ist. In einem bevorzugten Ausführungsbeispiel ist der Lesekopf 2 mittels des Kopfgehäuses 4 an einem Rahmen der (nicht dargestellten) Schutzeinrichtung oder der Maschine selbst festgelegt.

Der Elektromagnet 7 weist ein im wesentlichen kreiszylindrisches Gehäuse auf, das auf seiner dem Betätiger 3 zugewandten Seite eine im wesentlichen kreisförmige erste und vorzugsweise plane Anlagefläche 8 ausbildet. Radial außenseitig bildet das Gehäuse des Elektromagneten 7 einen ringförmigen und vorzugsweise planen Rand 9 aus, der von der ersten Anlagefläche 8 durch eine ringförmige Nut 28 beabstandet ist. Die erste Anlagefläche 8, der ringförmige Rand 9 und die Frontfläche 6 liegen vorzugsweise in einer planen Ebene.

Oberhalb des Elektromagneten 7 ist in dem Kopfgehäuse 4 die erste Baugruppe 10 unbeweglich festgelegt, insbesondere lösbar oder unlösbar mit dem Kopfgehäuse 4 verschraubt. Die Verdrahtung zwischen der ersten Baugruppe 10, dem Elektromagneten 7 und dem Anschluß für den Steckverbinder 5 erfolgt vorzugsweise innerhalb des Kopfgehäuses 4. An einer Seitenfläche ist an dem Kopfgehäuse 4 eine Kabelschelle 11 zur Fixierung der Anschlußleitungen für die Steckverbinder 5 angeordnet. Die vorzugsweise plane Frontfläche oder dritte Anlagefläche 23 (Fig. 4) der ersten Baugruppe 10 fluchtet mit der ersten Anlagefläche 8 oder ist dieser gegenüber geringfügig zurückversetzt.

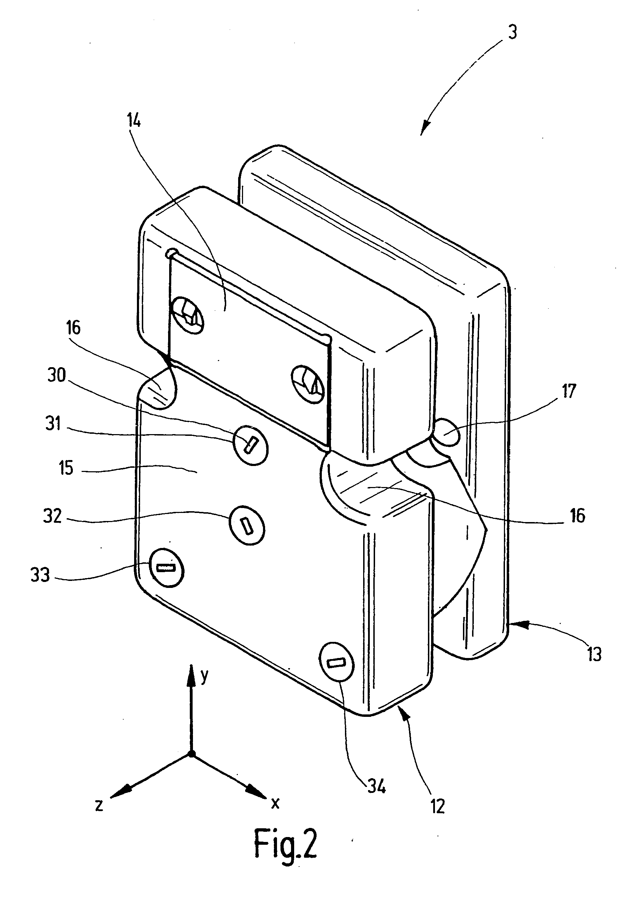

Die Fig. 2 zeigt eine perspektivische Ansicht eines zugehörigen Betätigers 3, der ein Gegenelement 12 aufweist, beispielsweise aus Stahl, mit dem der Betätiger 3 am Lesekopf 2 durch den Elektromagneten 7 fixierbar und damit die Schutzeinrichtung zuhaltbar ist. Das Gegenelement 12 kann einstückig aus Stahl sein oder nur teilweise, beispielsweise unter Bildung eines Rahmens aus Aluminium zur Aufnahme eines mit dem Elektromagneten zusammenwirkenden Einsatzstückes. Das Gegenelement 12 ist mit einem zugehörigen Grundelement 13, beispielsweise aus Aluminium, fest verbunden, aber diesem gegenüber schwenkbar, wie bei der nachfolgenden Beschreibung zu der Fig. 4 erläutert wird. Die mit der ersten Baugruppe 10 des Lesekopfes 2 elektrisch kontaktlos in Wechselwirkung bringbare zweite Baugruppe 14 ist fest mit dem Gegenelement 12 verbunden, vorzugsweise lösbar mittels Befestigungsschrauben an diesem festgelegt.

Das Gegenelement 12 bildet eine vorzugsweise plane zweite Anlagefläche 15 aus, die bei der Zuhaltung an die erste Anlagefläche 8 des Lesekopfes 2 in flächige Anlage bringbar ist. Die vorzugsweise plane Frontfläche oder vierte Anlagefläche 24 (Fig. 4) der zweiten Baugruppe 14 fluchtet mit der zweiten Anlagefläche 15 oder ist dieser gegenüber geringfügig zurückversetzt. Wesentlich ist dabei, dass durch die Anordnung der ersten und zweiten Baugruppe 10, 14 das Kontaktieren der ersten und zweiten Anlagefläche 8, 15 des Elektromagneten 7 bzw. des Gegenelements 12 gewährleistet ist, weil dadurch besonders hohe Zuhaltekräfte erzielbar sind.

Der Betätiger 3 ist beispielsweise mittels des Grundelements 13 an einer Schutzeinrichtung für eine von dem Sicherheitsschalter schaltbaren Maschine festgelegt. Gegenüber dieser Schutzeinrichtung ist das Gegenelement 12 zusammen mit der zweiten Baugruppe 14 um die drei in der Fig. 2 dargestellten und miteinander jeweils einen rechten Winkel einschließenden Raumrichtungen x, y, z schwenkbar. Die Abstandsrichtung zwischen Gegenelement 12 und Grundelement 13 ist dabei durch die Raumrichtung z repräsentiert. In dieser Abstandsrichtung z ist das Gegenelement 12 gegenüber dem Grundelement 13 im wesentlichen nicht verschiebbar. Sowohl das Gegenelement 12 als auch das Grundelement 13 weisen eine im wesentlichen quaderförmige Grundgestalt auf mit abgerundeten Kanten und Ecken. Die nutenförmigen Ausnehmungen 16 im Gegenelement 12 dienen der Zugänglichkeit für Befestigungsmittel, insbesondere Schrauben, die in die Befestigungslöcher 17 im Grundelement 13 einführbar sind und mittels denen der Betätiger 3 an dem beweglichen Teil der Schutzeinrichtung festlegbar ist.

In dem dargestellten Ausführungsbeispiel weist die zweite Baugruppe 14 keine Anschlußleitungen auf, so dass eine elektrische Kontaktierung des Betätigers 3 nicht erforderlich ist. Vorzugsweise wird über die im Lesekopf 2 angeordnete erste Baugruppe 10 Energie in die zweite Baugruppe 14 im Betätiger 3 übertragen, um in der zweiten Baugruppe 14 gespeicherte Identifikationsdaten auszulesen und zur ersten Baugruppe 10 zurück zu übertragen. In einer vereinfachten Ausführung kann die zweite Baugruppe 14 auch lediglich ein von der ersten Baugruppe 10 erzeugtes elektromagnetisches Wechselfeld in vorgebbarer Weise dämpfen und dadurch der ersten Baugruppe 10 bzw. dem Lesekopf 2 die Anwesenheit der zweiten Baugruppe 14 und damit die geschlossene Stellung der Schutzeinrichtung anzeigen.

Im wesentlichen zentrisch in Bezug auf die zweite Anlagefläche 15 sowie an den Eckpunkten eines gedachten gleichschenkligen Dreiecks sind im dargestellten Ausführungsbeispiel insgesamt vier Sensorelemente 31, 32, 33, 34 angeordnet. Jedes der Sensorelemente ist in eine entsprechende und im Ausführungsbeispiel kreisrunde Scheibe aus Kunststoff oder dergleichen eingebettet oder an dieser festgemacht. Diese Kunststoffscheibe weist als Einstellmittel 30 einen Einstellschlitz auf, mittels dem die Position des zugehörigen Sensorelements 31 in Richtung der z-Achse einstellbar ist. Durch das im Zentrum angeordnete zweite Sensorelement 32 ist detektierbar, ob überhaupt ein relevantes Magnetfeld im Umfeld des Betätigers 3 vorhanden ist. Die an den Eckpunkten des gedachten dreischenkligen Dreiecks angeordneten ersten, dritten und vierten Sensorelemente 31, 33, 34 erlauben darüber hinaus, die Ermittlung der Relativposition des Betätigers 3, insbesondere des Gegenelements 12, in Bezug auf das ggf. vorhandene Magnetfeld. Die Verknüpfung der Ausgangssignale der Sensorelemente 31, 32, 33, 34 erfolgt vorzugsweise unter Verwendung der elektrischen und/oder elektronischen Bauelemente in der zweiten Baugruppe 14.

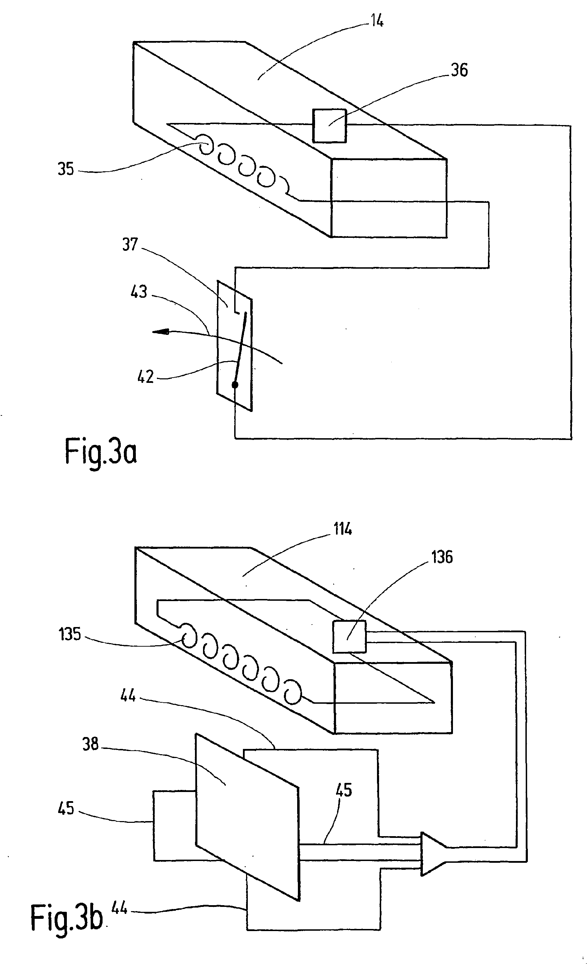

Die Fig. 3a zeigt ein erstes Ausführungsbeispiel der zweiten Baugruppe 14, in der eine Generatorspule 35 sowie ein Transponder 36 angeordnet sind. Ein im dargestellten Ausführungsbeispiel außerhalb der zweiten Baugruppe 14 angeordneter Reed-Kontakt 37 ist elektrisch in Reihe mit der Generatorspule 35 geschaltet. Im Falle einer Annäherung des Reed-Kontaktes 37 an das durch den Elektromagneten 7 generierte Magnetfeld kommt es zu einem Auslenken der Kontaktzunge 42 des Reed-Kontaktes 37 in Betätigungsrichtung 43 und damit zu einem elektrischen Verbinden des Transponders 36 mit der Generatorspule 35. Anstelle eines Schließer-Kontaktes kann auch ein Öffner-Kontakt verwendet werden, der im nichtbetätigten Zustand die Generatorspule 35 kürzschließt und damit einen Signalaustausch zwischen der ersten und zweiten Baugruppe 10, 14 verhindert.

Sowohl die zweite Baugruppe 14 als auch der Reed-Kontakt 37 sind an oder in dem Betätiger 3 angeordnet, so daß gleichzeitig mit der Bewegung des Reed-Kontaktes 37 bzw. Betätigers 3 auch die zweite Baugruppe 14 an die im Lesekopf 2 angeordnete erste Baugruppe 10 angenähert wird. Von einer entsprechenden Sendespule in der ersten Baugruppe 10 wird ein elektromagnetisches Signal ausgesendet, welches in der Generatorspule 35 empfangen wird und jedenfalls teilweise in elektrische Energie zurück verwandelt wird. Mit Hilfe dieser elektrischen Energie wird ein im Transponder 36 gespeichertes Datensignal ausgelesen und mittels der Generatorspule 35 auf die erste Baugruppe 10 des Lesekopfes zurück übertragen. Dieses Auslesen kann jedoch nur erfolgen, wenn die Kontaktzunge 42 ausgelenkt ist, was nur dann der Fall ist, wenn das von dem Elektromagneten 7 generierte Magnetfeld am Ort des Reed-Kontaktes 37 einen vorgebbaren Betrag aufweist, gemäß dem beispielsweise eine Zuhaltung in ausreichendem Maß gewährleistet ist.

Die Fig. 3b zeigt ein zweites Ausführungsbeispiel der zweiten Baugruppe 114, bei welcher der Transponder 136 unmittelbar an die Generatorspule 135 angeschlossen ist. Von der zweiten Baugruppe 114 beabstandet ist als Sensorelement ein Hall-Element 38 angeordnet, welches über die Zuleitungen 44 von dem Transponder 136 gespeist wird und dessen Ausgangsleitungen 45 zur Auswertung in den Transponder 136 zurückgeführt werden.

Die Fig. 4 zeigt einen Schnitt in der y/z-Ebene durch den Lesekopf 2 und den Betätiger 3 des Zuhaltesystems 1 im zusammengeführten Zustand. In dem dargestellten Querschnitt ist insbesondere die Form des federelastisch verformbaren Elements 18 erkennbar, das rotationssymmetrisch in Bezug auf die Abstandsrichtung z ausgebildet ist. Die Unterlegscheibe 20 ist im wesentlichen topfförmig ausgebildet und bildet einen Anschlag insbesondere beim Zuhalten und der damit verbundenen Kraftübertragung von dem Gegenelement 12 über das Verbindungselement 19 auf das Grundelement 13, und damit vom Lesekopf 2 auf den Betätiger 3 bzw. die Schutzeinrichtung, und/oder beim Eindrehen des Verbindungselements 19 und/oder beim Verschwenken des Gegenelements 12 gegenüber dem Grundelement 13. Die Tülle 18 ist dabei sowohl in Anlage an dem Grundelement 13 als auch an dem Verbindungselement 12, und dämpft bei auftretenden Vibrationen oder Stößen die Schwingungsneigung des Gegenelements 12 und verhindert dadurch eine Geräuschentwicklung bzw. ein Klappern, beispielsweise verursacht durch ein Anschlagen des Gegenelements 12 am Grundelement 13.

Das erste Sensorelement 31 ist in eine Gewindebohrung 41 in das Gegenelement einschraubbar, und zwar gegen die Wirkung eines kraftspeichernden Elementes 40, im Ausführungsbeispiel eine Schraubenfeder. Das Einschrauben erfolgt vorzugsweise durch einen Werkzeugeingriff in den Einstellschlitz 30, ggf. auch unter Verwendung einer geeigneten Münze. Die elektrische Kontaktierung des elektrischen Sensorelements 31 ist in der Fig. 4 aus Gründen der Übersichtlichkeit nicht dargestellt und kann beispielsweise über ausreichend lange Anschlußleitungen erfolgen, die im weiteren Verlauf mit der zweiten Baugruppe 14 in Verbindung stehen. Durch Ein- bzw. Ausdrehen des ersten Sensorelements 31 kann der Schwellenwert eingestellt werden, bei dessen Erreichen das erste Sensorelement 31 ein vorgebbares Ausgangssignal abgibt. Die Einstellung des ersten Sensorelements 31 erfolgt im gezeigten Ausführungsbeispiel lediglich in z-Richtung, kann durch entsprechende Einstelleinrichtungen allerdings auch in x- und y-Richtung erfolgen.

Abweichend von dem in der Fig. 4 dargestellten Ausführungsbeispiel kann es vorteilhaft sein, mindestens ein Sensorelement 31, 32, 33, 34 nahe oder an der dem Grundelement 13 zugewandten Fläche des Gegenelements 12 anzuordnen, jedenfalls von der ersten Ablagefläche 8 des Gegenelements 12 zurückversetzt. Insbesondere das Sensorelement 31, 32, 33, 34 und/oder auch das zugehörige Einstellmittel 30 können von dieser Rückseite zugänglich sein. Dadurch kann eine mindestens bereichsweise geschlossene erste Anlagefläche 8 des Gegenelements 12 bereitgestellt werden und das Sensorelement 31, 32, 33, 34 und/oder das zugehörige Einstellmittel 30 sind geschützt angeordnet.

Die Betätigung des Einstellmittels 30, vorallem in Richtung der z-Achse, kann dabei über Durchgangslöcher im Grundelement 13 und/oder im Verbindungselement 19 erfolgen. Die Längsachse eines Reed-Kontaktes 37 und/oder dessen Schaltrichtung kann im wesentlichen parallel zur z-Achse verlaufen oder mit dieser einen im wesentlichen rechten Winkel einschließen.

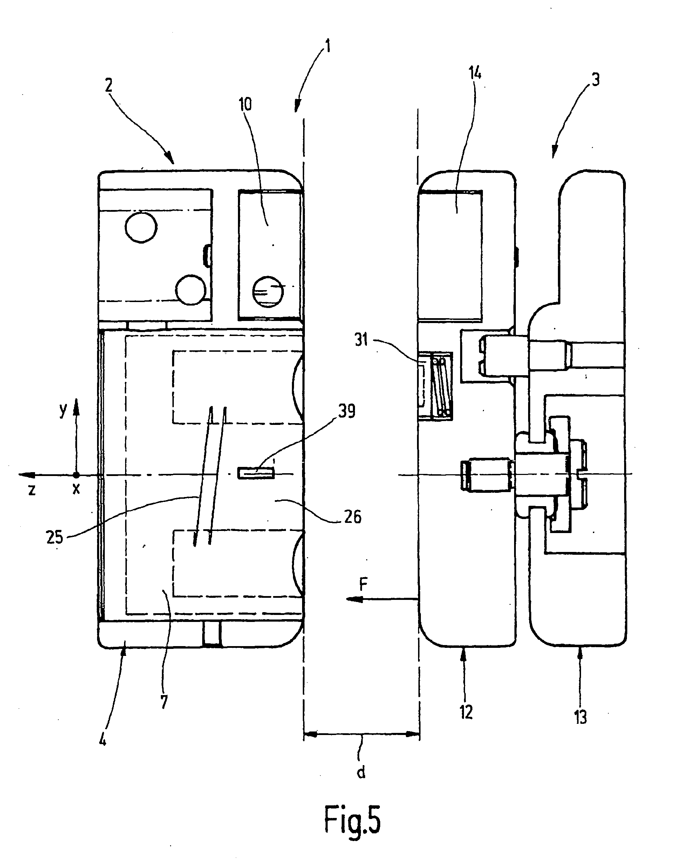

Die Fig. 5 zeigt das Zuhaltesystem 1 in einem Zustand, in dem der Betätiger 3 von dem Lesekopf 2 einen Abstand d aufweist. Der in dem Lesekopf 2 angeordnete Elektromagnet 7 ist gestrichelt eingezeichnet und weist mehrere Windungen 25 auf. Bei einer Bestromung der Windungen 25 wird im Spulenkern 26 ein magnetisches Feld induziert. Ein im Spulenkern 26 angeordnetes weiteres Hall-Element 39 ermittelt die auftretende Feldstärke. Diese ist unter anderem abhängig vom Abstand d des den magnetischen Fluß kurzschließenden Gegenelements 12 des Betätigers 3. Insbesondere erhöht sich die von dem weiteren Hall-Element 39 ermittelte Feldstärke und damit die zugehörige Hall-Spannung U_{Hall} mit abnehmenden Abstand d.

Alternativ oder ergänzend kann auch das erste Sensorelement 31 im Betätiger 3 als Hall-Element ausgebildet sein und die im Betätiger 3 austretende magnetische Feldstärke bzw. die zugehörige magnetische Induktion messen, die ebenfalls abhängig ist vom Abstand d des Betätigers 3 zum Lesekopf 2 bzw. zum Elektromagneten 7.

Die vom weiteren Hall-Element 39 und/oder vom ersten Sensorelement 31 gemessene magnetische Feldstärke ist ein Maß für die zwischen dem Lesekopf 2 und dem Betätiger 3 wirkende Zuhaltekraft F, die bei fest montiertem Lesekopf 2 insbesondere auf den Betätiger 3 und in Richtung auf den Lesekopf 2 wirkt. Dementsprechend können für das weitere Hall-Element 39 und/oder das erste Sensorelement 31 Schwellenwerte vorgegeben werden, bei deren Erreichen der Steuereinrichtung einer Maschine signalisiert werden kann, daß nicht nur die Schutzeinrichtung geschlossen ist, sondern daß auch eine ausreichend hohe Zuhaltekraft ansteht, um die Schutzeinrichtung sicher in dem geschlossenen Zustand zu halten. Wird hierzu das erste Sensorelement 31 im Betätiger 3 verwendet, kann von dem Erreichen des vorgebbaren Schwellenwertes für die Zuhaltekraft F abhängig gemacht werden, ob ein Signalaustausch zwischen der ersten und zweiten Baugruppe 10, 14 zwischen Betätiger 3 und Lesekopf 2 möglich ist.

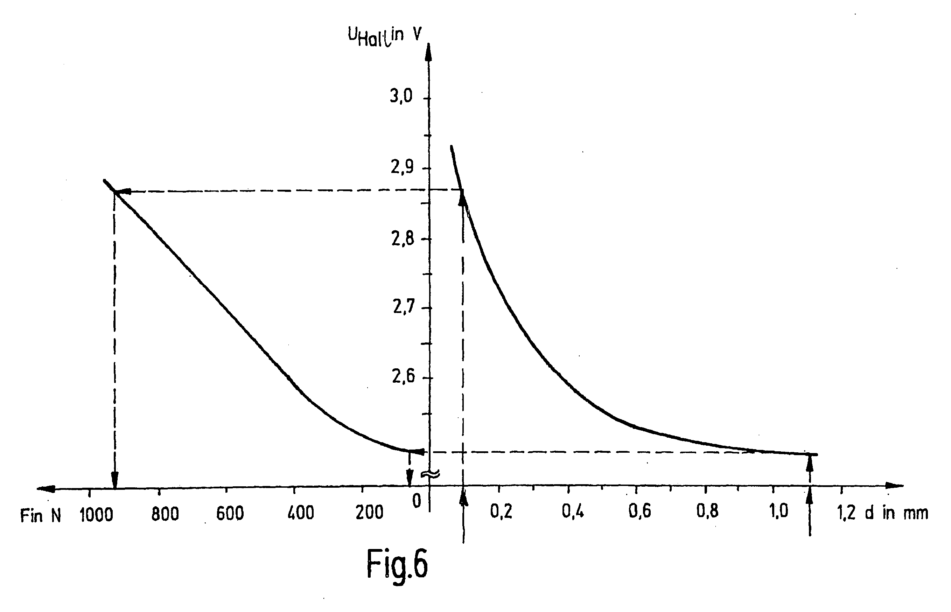

Die Fig. 6 zeigt ein Diagramm einer gemessenen Zuhaltekraft F in Abhängigkeit des Abstandes d zwischen Betätiger 3 und Lesekopf 2 bei einem Zuhaltesystem 1 gemäß der Fig. 4. Der Abstand d wurde zwischen 0,1 mm und 1,1 mm variiert. Die mit dem weiteren Hall-Element 39 gemessenen Hall-Spannungen U_{Hall} können entsprechend einer empirisch gewonnenen Kennlinie Zuhaltekräften F zugeordnet werden.
Die Zuordnung von gemessener Hall-Spannung U_{Hall} zur Zuhaltekraft F ist insbesondere abhängig von der Anordnung des weiteren Hall-Elements 39 in Bezug auf den Elektromagneten 7, von der Geometrie des Elektromagneten 7 und von der Geometrie sowie dem Werkstoff des Gegenelements 12 am Betätiger 3.

Die in der Regel an einem Baumuster empirisch ermittelten Wertepaare U_{Hall}/F können mittels eines elektronischen Datenspeichers in einer Nachschlagtabelle abgespeichert werden, oder es können aus den empirisch gewonnenen Werten für das jeweilige Zuhaltesystem 1 spezifische Schwellenwerte definiert werden. Die dargestellten Meßwerte gehen von einer Nennbestromung des Elektromagneten 7 aus. Hierfür wurde bei einem Abstand d = 0,1 mm eine Hall-Spannung von etwa 2,87 Volt gemessen, was einer Zuhaltekraft von mehr als 900 N entspricht. Bei einem Abstand d = 1,1 mm wurde eine Hall-Spannung von etwa 2,50 Volt gemessen, was einer Zuhaltekraft von etwa 60 N entspricht.

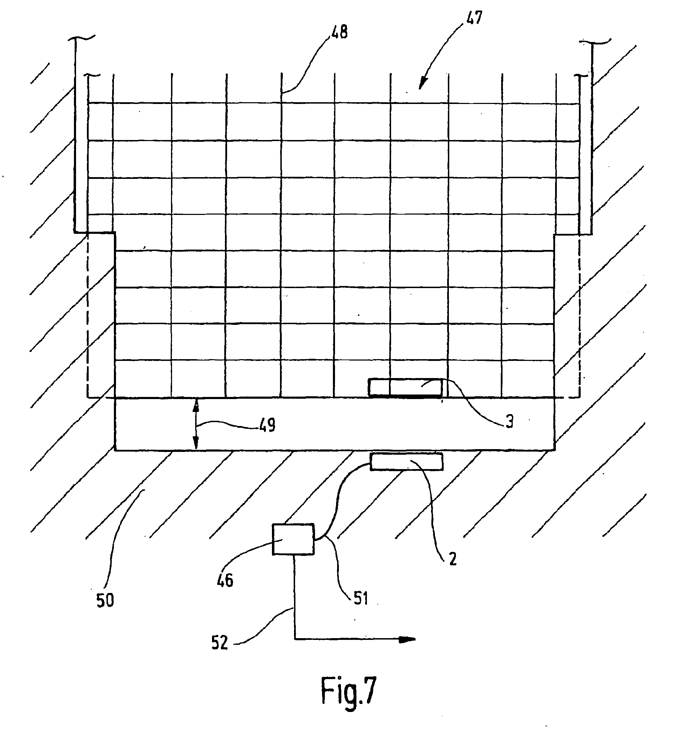

Die Fig. 7 zeigt in schematischer Darstellung eine Schutzeinrichtung 47, beispielsweise mit einem Schutzgitter 48, mit dem der Arbeitsbereich einer Werkzeugmaschine verschließbar ist, insbesondere um Bedienpersonen zu schützen und einem Zugriff auf die Werkzeugmaschine während des Betriebes zu verhindern. Das Schutzgitter 48 ist an einem fest montierten Rahmen 50 in Richtung des Doppelpfeil 49 verschiebbar. Der an dem Schutzgitter 48 festgelegte Betätiger 3 wirkt in geschlossenem Zustand mit dem Lesekopf 2 zusammen, insbesondere erfolgt ein Signalaustausch zwischen den beiden Baugruppen 10, 14. Der geschlossene Zustand des Schutzgitters 48 ist mittels des Elektromagneten 7 fixierbar. Der Lesekopf 2 ist über die Verbindungsleitung 51 mit der Auswerteeinheit 46 verbunden, sofern diese nicht im Lesekopf integriert ist. Die Auswerteeinheit 46 leitet über die Steuerleitung 52 Signale an die Steuereinrichtung der Werkzeugmaschine weiter, insbesondere um den geschlossenen Zustand des Schutzgitters 48 zu signalisieren und damit die Freigabe für den Betrieb der Werkzeugmaschine anzuzeigen, bzw. empfängt von der Steuereinrichtung Signale, insbesondere zur Aktivierung des Elektromagneten 7 um den geschlossenen Zustand des Schutzgitters 48 während des Betriebs der Werkzeugmaschine zu fixieren.

## Patentansprüche

1. Zuhaltesystem (1) eines Sicherheitsschalters mit einem Lesekopf (2) und einem Betätiger (3), die jeweils eine erste bzw. zweite Baugruppe (10, 14) mit elektrischen und/oder elektronischen Bauelementen aufweisen, die elektrisch kontaktlos in Wechselwirkung miteinander bringbar sind und **dadurch** den Sicherheitsschalter steuern, wobei der Betätiger (3) am Lesekopf (2) mittels eines mit einem Gegenelement (12) zusammenwirkenden schaltbaren Elektromagneten (7) zuhaltbar ist, und wobei mittels eines Sensorelements (31, 32, 33, 34), dessen Ausgangssignal abhängig ist von dem durch den Elektromagneten (7) generierbaren Magnetfeld, die Zuhaltung kontrollierbar ist,
**dadurch gekennzeichnet, dass** mit dem Sensorelement (31, 32, 33, 34) die Höhe der von dem Magnetfeld des Elektromagneten (7) hervorgerufenen Zuhaltekraft kontrollierbar ist.

2. Zuhaltesystem nach Anspruch 1, **dadurch gekennzeichnet, dass** das Sensorelement (31, 32, 33, 34) ein analoges Ausgangssignal betreffend die Stärke des von dem Elektromagneten (7) generierbaren Magnetfeldes erzeugt.

3. Zuhaltesystem nach einem der Ansprüche 1 bis 2, **dadurch gekennzeichnet, dass** die Höhe der Zuhaltekraft einstellbar ist.

4. Zuhaltesystem nach einem der Ansprüche 1 bis 3, **dadurch gekennzeichnet, dass** das Sensorelement (31, 32, 33, 34) das vom Elektromagneten (7) generierbare Magnetfeld mißt und unter Berücksichtigung der geometrischen Anordnung und der magnetischen Eigenschaften der Werkstoffe des Lesekopfs (2) und des Betätiger (3) aus dem gemessenen Magnetfeld die zwischen Lesekopf (2) und Betätiger (3) wirkende Zuhaltekraft ermittelt.

5. Zuhaltesystem nach einem der Ansprüche 1 bis 4, **dadurch gekennzeichnet, dass** das Sensorelement (31, 32, 33, 34) an dem Betätiger (3) angeordnet ist.

6. Zuhaltesystem nach einem der Ansprüche 1 bis 5, **dadurch gekennzeichnet, dass** das Sensorelement (31, 32, 33, 34) an dem Lesekopf (2) angeordnet ist.

7. Zuhaltesystem nach einem der Ansprüche 1 bis 6, **dadurch gekennzeichnet, dass** von dem Sensorelement (31, 32, 33, 34) in Abhängigkeit des von dem Elektromagneten (7) generierbaren Magnetfeldes zwei Schaltzustände einnehmbar sind, und dass die in dem Betätiger (3) angeordnete zweite Baugruppe (14) von den Schaltzuständen des Sensorelements (31, 32, 33, 34) gesteuert ist.

8. Zuhaltesystem nach einem der Ansprüche 1 bis 7, **dadurch gekennzeichnet, dass** in dem Betätiger (3) eine Generatorspule (35) zur elektrischen Energieversorgung der zweiten Baugruppe (14) angeordnet ist.

9. Zuhaltesystem nach Anspruch 8, **dadurch gekennzeichnet, dass** das Sensorelement (31, 32, 33, 34) elektrisch in Reihe mit der Generatorspule (35) geschaltet ist.

10. Zuhaltesystem nach einem der Ansprüche 1 bis 9, **dadurch gekennzeichnet, dass** mehrere Sensorelemente (31, 32, 33, 34) angeordnet sind, deren Ausgangssignale zur Kontrolle der Zuhaltung in einer vorgebbaren Weise miteinander verknüpft sind.

11. Zuhaltesystem nach einem der Ansprüche 1 bis 10, **dadurch gekennzeichnet, dass** durch ein Einstellmittel (30) die Position des Sensorelements (31, 32, 33, 34) einstellbar ist.

12. Zuhaltesystem nach einem der Ansprüche 1 bis 11, **dadurch gekennzeichnet, dass** das Sensorelement (31, 32, 33, 34) einen Reed-Kontakt (37) aufweist.

13. Zuhaltesystem nach einem der Ansprüche 1 bis 12, **dadurch gekennzeichnet, dass** das Sensorelement (31, 32, 33, 34) ein Hall-Element (38) aufweist.

14. Zuhaltesystem nach einem der Ansprüche 1 bis 13, **dadurch gekennzeichnet, dass** das Gegenelement (12) und/oder der Elektromagnet (7) mit einem zugehörigen und am Betätiger (3) bzw. am Lesekopf (2) festgelegten Grundelement (13) fest verbunden, aber diesem gegenüber schwenkbar ist.

## Claims

1. Locking system (1) of a safety switch having a reading head (2) and an actuator (3) which have a first and a second assembly (10, 14), respectively, with electrical and/or electronic components which can be brought into co-operation with each other in an electrically contact-free manner and thereby control the safety switch, the actuator (3) being able to be locked on the reading head (2) by means of a switchable electromagnet (7) which co-operates with a counter-element (12) and the locking being able to be controlled by means of a sensor element (31, 32, 33, 34) whose output signal is dependent on the magnetic field which can be generated by the electromagnet (7),
**characterised in that** the level of the locking force produced by the magnetic field of the electromagnet (7) can be controlled with the sensor element (31, 32, 33, 34).

2. Locking system according to claim 1, **characterised in that** the sensor element (31, 32, 33, 34) produces an analogue output signal relating to the strength of the magnetic field which can be generated by the electromagnet (7).

3. Locking system according to either claim 1 or claim 2, **characterised in that** the level of the locking force can be adjusted.

4. Locking system according to any one of claims 1 to 3, **characterised in that** the sensor element (31, 32, 33, 34) measures the magnetic field which can be generated by the electromagnet (7) and, taking into account the geometric arrangement and the magnetic properties of the materials of the reading head (2) and the actuator (3), establishes the locking force acting between the reading head (2) and actuator (3) from the measured magnetic field.

5. Locking system according to any one of claims 1 to 4, **characterised in that** the sensor element (31, 32, 33, 34) is arranged on the actuator (3).

6. Locking system according to any one of claims 1 to 5, **characterised in that** the sensor element (31, 32, 33, 34) is arranged on the reading head (2).

7. Locking system according to any one of claims 1 to 6, **characterised in that** the sensor element (31, 32, 33, 34) can assume two switching states depending on the magnetic field which can be generated by the electromagnet (7), and **in that** the second assembly (14) which is arranged in the actuator (3) is controlled by the switching states of the sensor element (31, 32, 33, 34).

8. Locking system according to any one of claims 1 to 7, **characterised in that** there is arranged in the actuator (3) a generator coil (35) for supplying electrical energy to the second assembly (14).

9. Locking system according to claim 8, **characterised in that** the sensor element (31, 32, 33, 34) is electrically connected in series with the generator coil (35).

10. Locking system according to any one of claims 1 to 9, **characterised in that** there is arranged a plurality of sensor elements (31, 32, 33, 34) whose output signals are combined with each other in order to control the locking in a predeterminable manner.

11. Locking system according to any one of claims 1 to 10, **characterised in that** the position of the sensor element (31, 32, 33, 34) can be adjusted by an adjustment means (30).

12. Locking system according to any one of claims 1 to 11, **characterised in that** the sensor element (31, 32, 33, 34) has a Reed contact (37).

13. Locking system according to any one of claims 1 to 12, **characterised in that** the sensor element (31, 32, 33, 34) has a Hall element (38).

14. Locking system according to any one of claims 1 to 13, **characterised in that** the counter-element (12) and/or the electromagnet (7) is/are securely connected to an associated base element (13) which is secured to the actuator (3) and to the reading head (2) but can be pivoted relative thereto.

## Revendications

1. Système (1) de verrouillage d'un interrupteur de sécurité, comprenant une tête (2) de lecteur et un actionneur (3) qui ont respectivement un premier et un deuxième modules (10, 14) ayant des composants électriques et/ou électroniques qui peuvent être mis électriquement sans contact en interaction mutuelle et commander ainsi l'interrupteur de sécurité, l'actionneur pouvant être verrouillé à la tête (2) de lecteur au moyen d'un électroaimant (7) pouvant être mis en circuit et coopérant avec un élément (12) antagoniste, et dans lequel le verrouillage peut être commandé au moyen d'un élément (31, 32, 33, 34) de capteur, dont le signal de sortie dépend du champ magnétique pouvant être produit par l'électroaimant (7),
**caractérisé en ce que** l'intensité de la force de verrouillage provoquée par le champ magnétique de l'électroaimant (7) peut être commandée par l'élément (31, 32, 33, 34) de capteur.

2. Système de verrouillage suivant la revendication 1, **caractérisé en ce que** l'élément (31, 32, 33, 34) de capteur produit un signal de sortie analogique concernant l'intensité du champ magnétique pouvant être produit par l'électroaimant (7).

3. Système de verrouillage suivant l'une des revendications 1 à 2, **caractérisé en ce que** l'intensité de la force de verrouillage est réglable.

4. Système de verrouillage suivant l'une des revendications 1 à 3, **caractérisé en ce que** l'élément (31, 32, 33, 34) de capteur mesure le champ magnétique pouvant être produit par l'électroaimant (7) et, en tenant compte de la disposition géométrique et des propriétés magnétiques des matériaux de la tête (2) de lecture et de l'actionneur (3), détermine à partir du champ magnétique mesuré la force de verrouillage agissant entre la tête (2) de lecture et l'actionneur (3).

5. Système de verrouillage suivant l'une des revendications 1 à 4, **caractérisé en ce que** l'élément (31, 32, 33, 34) de capteur est disposé sur l'actionneur.

6. Système de verrouillage suivant l'une des revendications 1 à 5, **caractérisé en ce que** l'élément (31, 32, 33, 34) de capteur est disposé sur la tête (2) de lecture.

7. Système de verrouillage suivant l'une des revendications 1 à 6, **caractérisé en ce qu'**il peut être perçu par l'élément (31, 32, 33, 34) de capteur deux états de commutation en fonction du champ magnétique pouvant être produit par l'électroaimant et **en ce que** le deuxième module (14) disposé sur l'actionneur (3) est commandé par les états de commutation de l'élément (31, 32, 33, 34) de capteur.

8. Système de verrouillage suivant l'une des revendications 1 à 7, **caractérisé en ce qu'**une bobine (35) de générateur, pour l'alimentation en énergie électrique du deuxième module (14), est disposée dans l'actionneur (3).

9. Système de verrouillage suivant la revendication 8, **caractérisé en ce que** l'élément (31, 32, 33, 34) de capteur est monté électriquement en série avec la bobine (35) de générateur.

10. Système de verrouillage suivant l'une des revendications 1 à 9, **caractérisé en ce qu'**il est disposé plusieurs éléments (31, 32, 33, 34) de capteur, dont les signaux de sortie sont, pour le contrôle du verrouillage, combinés entre eux d'une façon pouvant être prescrite.

11. Système de verrouillage suivant l'une des revendications 1 à 10, **caractérisé en ce que** la position de l'élément (31, 32, 33, 34) de capteur peut être réglée par un moyen (30) de réglage.

12. Système de verrouillage suivant l'une des revendications 1 à 11, **caractérisé en ce que** l'élément (31, 32, 33, 34) de capteur comporte un contact (37) Reed.

13. Système de verrouillage suivant l'une des revendications 1 à 12, **caractérisé en ce que** l'élément (31, 32, 33, 34) de capteur comporte un élément (38) Hall.

14. Système de verrouillage suivant l'une des revendications 1 à 13, **caractérisé en ce que** l'élément (12) antagoniste et/ou l'électroaimant (7) sont assemblés fixement à un élément (13) de base associé et fixé à l'actionneur (3) ou à la tête (2) de lecture, mais peuvent pivoter par rapport à celui-ci.
